# FASCICULE DE BREVET EUROPEEN

(11) **EP 2 175 478 B1**
(45) Date de publication et mention de la délivrance du brevet: **17.05.2017**
(21) Numéro de dépôt: 10152671.3
(22) Date de dépôt: 29.12.1998
(51) Int. Cl.: H01L 21/265, H01L 21/762

(54) **Procédé pour le transfert d'un film mince comportant une étape de création d'inclusions**
Verfahren zum Übertragen eines Dünnfilms mit einem Einschlüsse erzeugenden Schritt
Method for transferring a thin film comprising a step of generating inclusions

(30) Priorité: 30.12.1997 FR 9716696
(43) Date de publication de la demande: 14.04.2010
(62) Demande divisionnaire de: 98964541.1
(73) Titulaire: Commissariat à l'Énergie Atomique et aux Énergies Alternatives, 75015 Paris (FR)
(72) Inventeur: Moriceau, Hubert, 38120, SAINT-EGREVE (FR); Bruel, Michel, 38113, VEUREY (FR); Aspar, Bernard, 38330 Saint-Ismier (FR); Maleville, Christophe, 38660 La Terrasse (FR)
(74) Mandataire: Colombo, Michel

(56) Documents cités:
- EP-A2- 0 767 486
- FR-A1- 2 748 850

## Description

### Domaine technique

La présente invention concerne un procédé pour le transfert d'un film mince de matériau solide. Ce procédé permet en particulier le transfert d'un film mince de matériau solide sur un support constitué d'un matériau solide de même nature ou de nature différente.

### Etat de la technique antérieure

Le document FR-A-2 681 472 (correspondant au brevet US-A-5 374 564) décrit un procédé de fabrication de films minces de matériau semiconducteur. Ce document divulgue que l'implantation d'un gaz rare ou d'hydrogène dans un substrat en matériau semiconducteur est susceptible de créer la formation d'une couche de microcavités ou de microbulles (encore désignées par le terme "platelets" dans la terminologie anglo-saxonne) à une profondeur voisine de la profondeur moyenne de pénétration (Rp) des ions implantés. La notion de microcavités inclut bien entendu les microfissures. L'épaisseur de la couche de microcavités est déterminée par les conditions d'implantation. Si ce substrat est mis en contact intime, par sa face implantée avec un raidisseur et qu'un traitement thermique est appliqué à une température suffisante, il se produit une interaction entre les microcavités ou les microbulles conduisant à une séparation du substrat semiconducteur en deux parties : un film mince semiconducteur adhérant au raidisseur d'une part, le reste du substrat semiconducteur d'autre part. La séparation a lieu à l'endroit où les microcavités ou microbulles sont présentes. Le traitement thermique est tel que l'interaction entre les microbulles ou microcavités créées par implantation induit une séparation entre le film mince et le reste du substrat. Il y a donc transfert d'un film mince depuis un substrat initial jusqu'à un raidisseur servant de support à ce film mince.

Ce procédé peut également s'appliquer à la fabrication d'un film mince de matériau solide autre qu'un matériau semiconducteur (un matériau conducteur ou diélectrique), cristallin ou non.

Si le film mince délimité dans le substrat est suffisamment rigide par lui-même (à cause de son épaisseur ou à cause de ses propriétés mécaniques) on peut obtenir, après le recuit de transfert, un film autoporté. C'est ce qu'enseigne le document FR-A-2 738 671.

Il a été proposé, par le document EP-A-0 767 486, une amélioration du procédé divulgué dans le document FR-A-2 681 472 cité plus haut. D'après le document EP-A-0 767 486 (voir la colonne 8), le procédé divulgué par le document FR-A-2 681 472 présente les inconvénients suivants. Le choix de l'épaisseur du film à transférer est d'un degré de liberté faible. L'épaisseur du film à transférer (correspondant à Rp) et les conditions de séparation du film d'avec le substrat initial sont liées. La planéité de la surface du film obtenu après la séparation n'est pas satisfaisante et il n'est pas possible de conserver l'homogénéité en épaisseur d'un film mince lors du transfert. L'amélioration proposée par le document EP-A-0 767 486 consiste à réaliser l'implantation d'ions à la profondeur Rp dans une couche de silicium poreuse formée à la surface d'un substrat en silicium. Cette implantation ionique provoque une augmentation de la porosité (densité de pores) dans la mesure où apparaissent des microcavités dans les parois des pores de la couche poreuse. Cette couche est alors considérée comme une structure poreuse fine. Sous certaines conditions d'implantation, la séparation est provoquée dans cette couche poreuse fine, conformément au mécanisme décrit dans le document FR-A-2-681 472. Il existe donc deux effets de zone de par une zone de pores créés par une étape de génération de silicium poreux, et de par une zone de cavités générées entre les pores dans les petites zones de silicium parfait comme pour le procédé selon le document FR-A-2 681 472. L'amélioration proposée consiste donc à utiliser une couche poreuse pour obtenir, après séparation, une couche dont l'homogénéité en épaisseur est bien contrôlée.

Le procédé divulgué par le document EP-A-0 767 486 préconise la formation de silicium poreux (la porosité est d'un pourcentage de l'ordre de plusieurs dizaines), ce qui revient à retirer du silicium ou de la matière au niveau de la zone de séparation et ce qui entraîne une fragilisation du matériau.

Une amélioration plus sensible du procédé révélé par le document FR-A-2 681 472 serait de réduire l'épaisseur de la couche de microcavités obtenue par implantation ionique. C'est ce que propose la présente invention.

De l'état de la technique est connu de EP0767486A2 et de FR2748850.

### Exposé de l'invention

L'amélioration proposée par la présente invention est rendue possible grâce à la création dans le matériau du substrat initial d'une inclusion ou d'un ensemble d'inclusions afin de confiner les espèces gazeuses implantées lors de l'étape d'implantation ionique. Une inclusion est un volume de matériau dont les propriétés sont différentes de celles du matériau du substrat à partir duquel on veut transférer un film mince ou des films minces. Les inclusions peuvent se présenter sous la forme d'une couche s'étendant sensiblement parallèlement à la surface au travers de laquelle on réalise l'implantation. Les formes que peuvent prendre ces volumes sont diverses et leurs dimensions peuvent aller de quelques dixièmes de nanomètres à plusieurs centaines de micromètres.

Le rôle des inclusions est d'être des pièges pour les espèces gazeuses implantées. Le rayon d'action de ces pièges dépend de la nature des inclusions réalisées. Il n'y a pas alors de retrait de matière, comme dans le cas du procédé divulgué par le document EP-A-0 767 486.

Le procédé selon la présente invention comprend une étape préliminaire consistant à former des inclusions dans le matériau du substrat initial. Une étape postérieure consiste à implanter des espèces gazeuses, de gaz rare ou non, dans ce matériau. La présence des inclusions formées à l'étape précédente entraîne un confinement des espèces gazeuses implantées. L'efficacité des inclusions est liée à leur pouvoir de confinement des espèces gazeuses.

Les inclusions peuvent être formées au voisinage d'une profondeur parfaitement contrôlable. Leur présence induit alors un confinement des espèces implantées dans une couche perturbée d'épaisseur plus fine que celle que l'on obtient dans le procédé de l'art connu. Il en résulte plusieurs avantages. Les espèces gazeuses implantées sont piégées préférentiellement au niveau et/ou dans la zone influencée par ces inclusions, dite voisinage de ces inclusions. Cette localisation précise permet d'induire une fracture de séparation (transfert) au niveau et/ou au voisinage des inclusions. Il en résulte une rugosité relativement faible de la surface au niveau de la fracture. De plus, dû au pouvoir de confinement, un tel procédé permet l'usage de faibles doses implantées nécessaires à la fracture. Enfin, l'effet de confinement par la présence des inclusions permet de diminuer le budget thermique nécessaire à la fracture, dans la mesure où l'on favorise la nucléation et la croissance des cavités amenant à la fracture. L'intérêt est évident dans le cas de transfert de structures en films pour lesquelles une limitation de montée en température existe. On peut citer, comme exemple, le collage hétérogène de matériaux ayant des coefficients de dilatation différents de plus de 10%.

L'invention a donc pour objet un procédé pour le transfert d'au moins un film mince de matériau solide délimité dans un substrat initial conforme à la revendication 1.

L'étape d'implantation des espèces gazeuses peut être réalisée avec une énergie d'implantation de ces espèces gazeuses telle que leur profondeur moyenne de pénétration dans le substrat correspond à la profondeur de la couche d'inclusions. Elle peut aussi être réalisée avec une énergie d'implantation de ces espèces gazeuses telle que leur profondeur moyenne de pénétration dans le substrat est au voisinage de la couche d'inclusions, cette implantation étant associée avec un traitement thermique de diffusion pour permettre la migration des espèces implantées au niveau de la couche d'inclusions.

L'étape d'implantation peut être réalisée à partir d'une ou de plusieurs espèces gazeuses implantées soit simultanément, soit successivement.

Le substrat initial peut être constitué d'une partie massive supportant une structure en film(s) dans laquelle doit être délimité ledit film de matériau solide. Tout ou partie de cette structure peut être obtenu par épitaxie. Cette structure peut être telle que, après transfert du film mince, le reste du substrat, porteur ou non d'une épitaxie, est réutilisable pour un autre transfert de film mince.

La couche d'inclusions peut être formée par une technique de dépôt de film. Elle peut alors consister en une génération de colonnes ou une génération de grains.

Les inclusions peuvent présenter une affinité chimique avec lesdites espèces gazeuses.

Les inclusions peuvent provenir d'un désaccord paramétrique du matériau formant la couche d'inclusions avec les régions du substrat qui lui sont adjacentes. Ce désaccord paramétrique peut consister en un écart de dimension des paramètres cristallins, en écarts d'orientation cristalline dans un plan parallèle à la surface de la structure transférée, en différence de coefficient de dilatation thermique entre un des films et le matériau initial (et/ou d'autres films).

La couche d'inclusions peut aussi être formée par une technique de gravure d'une couche du substrat.

La couche d'inclusions peut être formée par implantation d'éléments dans une couche du substrat. Ces éléments peuvent être implantés en une ou plusieurs fois. L'implantation de ces éléments peut être assistée par un traitement thermique apte à augmenter l'efficacité des pièges, ce traitement thermique pouvant être effectué avant, pendant et/ou après l'implantation. Ce traitement thermique est apte à modifier la morphologie et/ou la composition des inclusions, ce qui favorise le confinement ultérieur des espèces gazeuses. Ce traitement thermique est réalisé à une température et pendant une durée telle qu'il ne permet pas de réaliser une fracture sur l'ensemble de la couche d'inclusions.

La couche d'inclusions peut encore être obtenue par traitement thermique du ou des films et/ou par application de contraintes au(x) film(s) de la d'une structure en film(s).

La couche d'inclusions peut encore être obtenue par une combinaison des différentes techniques citées ci-dessus.

L'introduction des espèces gazeuses peut être réalisée par l'implantation par bombardement d'espèces choisies parmi les espèces neutres et les ions. Elle peut encore être réalisée par une méthode choisie parmi la diffusion assistée par plasma, la diffusion thermique et la diffusion assistée par plasma combinée avec la diffusion thermique et/ou assistée par polarisation électrique. L'implantation peut être effectuée de façon normale par rapport à la face implantée du substrat, ou avec une certaine incidence. Elle peut être effectuée en utilisant des éléments différents de gaz rares ou non.

Le procédé peut comprendre une étape de traitement thermique apte à fragiliser le substrat au niveau de la couche d'inclusions pour permettre la séparation entre le film mince et le reste du substrat. Ce traitement thermique est mené avec un budget thermique déterminé et qui est fonction des différents budgets thermiques utilisés au cours du procédé. En particulier, ce traitement thermique tient compte du ou des échauffements induits par des traitements thermiques de type hors équilibres thermodynamiques tels que ceux pouvant résulter de l'étape de formation des inclusions et/ou de l'étape d'implantation des espèces gazeuses et par des traitements thermiques utilisant un chauffage ou un refroidissement du substrat, tels que par exemple pour l'implantation, ou un éventuel renforcement de forces de liaison dans le cas du collage avec un support. Ce traitement thermique peut donc être nul si les autres étapes du procédé permettent ladite fragilisation. Il peut être réalisé aussi bien avec une température positive qu'avec une température négative. Selon l'invention, Cette fragilisation est telle qu'elle permet la séparation du film mince d'avec le reste du substrat avec ou sans l'utilisation de contraintes mécaniques. Ce traitement thermique peut être réalisé par chauffage impulsionnel afin d'obtenir par exemple une montée rapide en température. Ce chauffage impulsionnel peut être de type RTA ("Rapid Thermal Annealing") ou de type RTP ("Rapid Thermal Process") par exemple.

Le procédé peut comprendre en outre une étape de mise en contact intime du film mince délimité dans le substrat avec un support auquel le film mince adhèrera après sa séparation d'avec le reste du substrat. La mise en contact intime peut être réalisée directement (par adhésion moléculaire par exemple) ou par l'intermédiaire d'un matériau rapporté. Une étape de traitement thermique peut être mise en oeuvre pour renforcer l'adhésion entre le film mince délimité dans le substrat et le support rapporté.

Des contraintes mécaniques peuvent être exercées au cours et/ou après et/ou avant le traitement thermique pour contribuer à la séparation entre le film mince et le reste du substrat.

Le procédé selon l'invention s'applique avantageusement au transfert d'un film mince de silicium à partir d'un substrat initial. Il peut s'appliquer aussi au transfert d'un film mince de matériau semiconducteur III-V (par exemple de l'AsGa) à partir d'un substrat initial. Le film mince peut être constitué lui-même d'une structure en films minces. Il peut avoir été au moins partiellement traité avant son transfert pour y constituer, sur tout ou partie du film à transférer, un circuit intégré ou pour y constituer, sur tout ou partie du film à transférer, un composant optoélectronique.

### Brève description des dessins

L'invention sera mieux comprise au moyen de la description qui va suivre, donnée à titre d'exemple non limitatif, accompagnée des dessins annexés parmi lesquels :
- la figure 1 est une vue transversale d'un substrat formé d'un support initial sur lequel on a fait croître, par une technique de pulvérisation, une structure en films comportant une couche d'inclusions due à une croissance colonnaire ;
- la figure 2 est une vue transversale d'un substrat formé d'un support initial sur lequel on a fait croître, par une technique de pulvérisation, une structure en films comportant une couche d'inclusions due à une croissance granulaire ;

- les figures 3 et 4 sont des diagrammes représentant l'évolution du paramètre de réseau d'une composition cristalline en fonction de taux d'un élément implanté dans la composition ;
- la figure 5 est une vue transversale d'un substrat sur lequel des inclusions sont générées par gravure ;
- les figures 6A à 6D sont illustratives du procédé selon l'invention dans le cas où un film mince est transféré sur un raidisseur ;
- la figure 7 est une vue transversale d'un substrat permettant l'obtention d'une structure SOI différente du procédé selon l'invention.

### Description détaillée de modes de réalisation de l'invention

Le substrat à partir duquel sera transféré le film mince peut être un substrat massif (formé d'un matériau unique) ou un substrat composite, c'est-à-dire formé de films de natures chimiques et/ou physiques identiques ou différentes.

Les inclusions peuvent être générées dans le substrat initial en particulier par :
- un changement structural dans le matériau initial (structure cristalline, orientation cristalline, zones localement amorphes, lacunes...),
- un changement de nature physique (densification, inclusion de gaz pendant l'élaboration, par exemple implantation d'ions divers, gravure ionique et/ou chimique sélective et/ou électrochimique sur plusieurs couches...),
- un changement de nature chimique ou de liaisons chimiques (effet de dopage, effet de variation de composition, utilisation d'une interface d'une structure préalablement collée, nucléation et/ou croissance de précipités...),
- des déformations plus ou moins locales du matériau (effets d'interface, effet de traitements thermiques de couches à coefficients de dilatation différents, effet de contraintes générées entre couches, consécutives...).

Un certain nombre de techniques d'élaboration ou de traitements de matériaux en films permet de réaliser des inclusions, dans une zone relativement parallèle à la surface du matériau.

En termes d'applications, l'intérêt d'un tel procédé est de permettre par exemple un changement de substrat pour un ou plusieurs films empilés, pour une structure partiellement ou totalement traitée en vue de réaliser un composant de micro-électronique, un capteur... Ce besoin sera par exemple extrêmement important dans le cas où le film ou la structure transférés seraient à soumettre à des traitements thermiques que le support final ne pourrait supporter (température trop élevée, différence de dilatation thermique trop importante...).

Les diverses techniques de dépôt de films permettent de réaliser des empilements d'un ou de plusieurs films, dans lesquels on peut faire facilement varier la composition des films, leur état de contrainte, leur structure, leur morphologie. On entend par dépôt de films le fait de rapporter et/ou d'élaborer. Ces diverses possibilités permettent de générer des inclusions dans le matériau initial avant l'étape d'implantation d'espèces gazeuses. Les interfaces, le(s) film(s) et leur(s) voisinage(s) concernés sont considérés par la suite comme zone d'inclusions, pièges pour les espèces gazeuses implantées lors de la deuxième étape du procédé.

Les techniques de dépôt sont nombreuses et choisies suivant la nature des matériaux à élaborer. Les matériaux pourront être des matériaux amorphes, polycristallins ou monocristallins. Pour certaines applications, les dépôts devront être réalisés en épitaxie (homogène ou hétérogène). Parmi les techniques de dépôt les plus couramment utilisées, on peut citer : les dépôts par pulvérisation ionique, les dépôts par réaction en phase vapeur, à haute ou basse pression, assistés ou non par plasma, les dépôts par jet moléculaire, les dépôts par épitaxie en phase liquide, les dépôts assistés par ablation laser.

La technique de pulvérisation ionique permet des croissances en colonnes, d'orientations et de tailles variables. Ces tailles et orientations sont contrôlables suivant les conditions de pression, de température et d'énergie de dépôt. Au cours de la croissance colonnaire, certaines des colonnes sont arrêtées dans leur croissance au profit d'autres colonnes qui s'élargissent. A titre d'exemple, dans la réalisation de films de Co(Zr, Nb), une pression d'argon de l'ordre de 30 mTorr, pendant le dépôt, favorise une croissance colonnaire. Cet effet peut être utilisé pour imposer certaines propriétés magnétiques au dépôt par rapport au plan du support initial. Les zones, situées au niveau et/ou au voisinage de l'extrémité des colonnes arrêtées dans leur croissance, sont des zones d'inclusions.

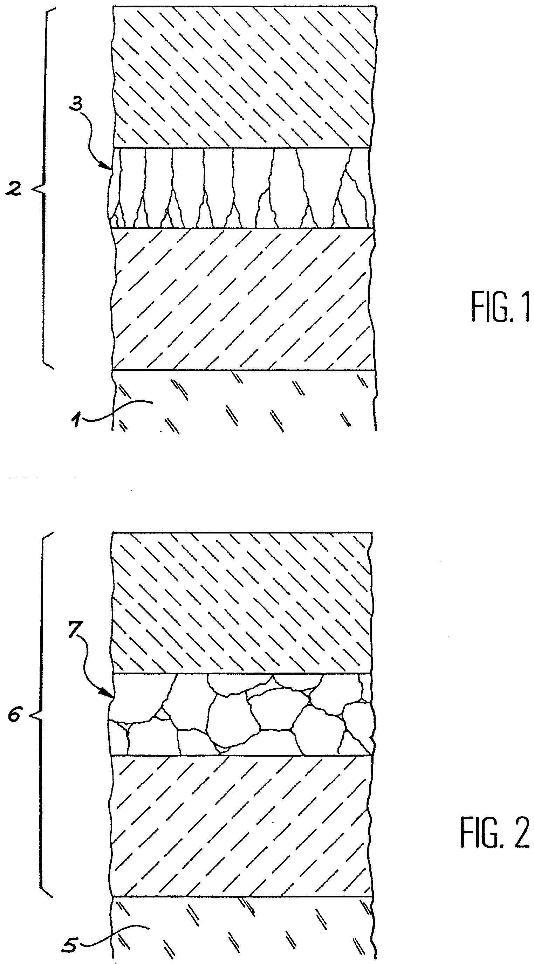

La figure 1 illustre un substrat ainsi obtenu. Il est formé d'un support initial 1, composite ou non, sur lequel on a fait croître une structure en film mince 2 par pulvérisation. Une croissance colonnaire a été provoquée à l'intérieur de la structure 2 pour constituer une couche d'inclusions 3 qui servira de zone de pièges pour les espèces gazeuses à implanter. La localisation de la surface de la fracture dans ou autour de la zone de pièges est fonction de l'efficacité des pièges créés.

Cette technique de dépôt permet également des croissances en grains (monocristallins, polycristallins ou en agglomérats amorphes) de dimensions moyennes, très bien contrôlables. A titre d'exemple, si Tm est la température de fusion du matériau à déposer, une température de dépôt T, telle que le rapport T/Tm est supérieur à 0,5, favorise la croissance en grains cristallins. On peut se référer à ce propos à l'article de A.G. DIRKS et H.J. LEAMY paru dans la revue Thin Solid Films, 47, 219, (1977). Les joints entre les grains sont également des zones d'inclusions pour le procédé selon la présente invention.

La figure 2 illustre un substrat ainsi obtenu. Il est formé d'un support initial 5, composite ou non, sur lequel on a fait croître une structure en film mince 6 par pulvérisation. Une croissance granulaire a été provoquée à l'intérieur de la structure 6 pour constituer une couche d'inclusions 7 qui servira de zone de pièges pour les espèces gazeuses à implanter. La localisation de la surface de fracture au niveau de la zone d'inclusions est fonction de l'efficacité des pièges créés.

En général, les techniques de dépôts de films permettent de disposer de films dont les épaisseurs peuvent être parfaitement contrôlées. Il est alors possible de réaliser des structures de faibles épaisseurs, composées de films simples ou multiples. Les dépôts de film(s) sont réalisés sans relation cristalline (avec le support initial et/ou entre les films) ou en épitaxie (homogène ou hétérogène). En outre, dans le terme de dépôts de films, il faut inclure les dépôts de films multicouches à effet tampon et/ou à effet d'adaptation (dits "seed layer" et "buffer layer" en anglais) dans le but de réaliser des structures cristallines. On remarquera que dans le cas d'une épitaxie homogène d'un film sur un support de même nature, l'interface, si elle existe, pourra être le lieu d'inclusions. Les espèces gazeuses implantées par la suite seront localisées au niveau et/ou au voisinage de cette interface.

Ces structures en film(s) sont tout ou partie de zones d'inclusions, étant donné :
- la nature physique et/ou chimique des films (interaction chimique entre les films, variation des orientations cristallines dans le cas de structures multicouches, affinité pour les espèces gazeuses qui seront implantées par la suite...),
- les contraintes présentes dans ces divers films et interfaces générés (du fait de désaccord de mailles cristallines, de différence de coefficients de dilatation thermique, de microrugosité d'interface, d'inclusions d'éléments autres que ceux du matériau à déposer, d'inclusions de phases hétérogènes...).

A titre d'exemple, il est possible de réaliser une structure multicouche dans laquelle au moins un film cristallin est déposé, séparé du support cristallin initial par un ou plusieurs films, dits couches tampons et/ou d'adaptation. Le film cristallin présente des orientations cristallines identiques ou non à celles du support initial. Le rôle des couches tampons est de provoquer sur tout ou partie de la surface de la plaquette des variations de l'orientation cristalline, en particulier dans le plan par rapport au support initial. Dans ce cas, on génère une zone de contraintes et/ou de dislocations permettant l'adaptation des mailles cristallines. Cette zone est située au voisinage des films cités. Il en est ainsi pour le dépôt de films supraconducteurs YBaCuO, en épitaxie sur des couches tampons de SrTiO₃ et/ou de CeO₂. Ces couches tampons sont en épitaxie sur un substrat de saphir de plan R(1102). La concordance de mailles impose une rotation de 45° des axes cristallins de type <001> dans le plan, en même temps qu'une forte contrainte au voisinage des interfaces ou dans le volume des films cités. Cette rotation de 45° peut être supprimée dans certaines zones par l'interposition dans ces mêmes zones d'un film très mince de MgO. On peut se référer à ce propos à l'article "Bi-Epitaxial YBCO Grain Boundary Josephson Junctions on SrTiO3 and Sapphire Substrates" de S. NICOLETTI et al., paru dans la revue Physica C 269 (1996) 255-267.

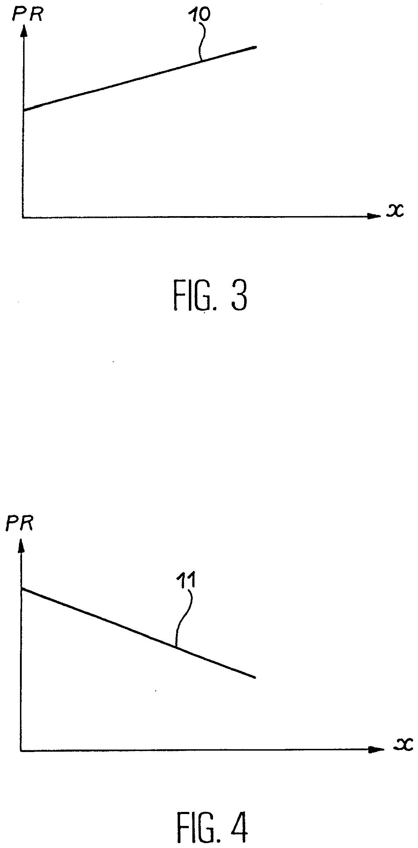

Comme autre exemple lié aux contraintes dues aux désaccords de mailles cristallines, on peut citer les dépôts par phase vapeur (CVD) de films de Si₍₁₋ₓ₎Geₓ sur support de silicium. La contrainte sera contrôlée en fonction de la concentration x de germanium dans la composition du film. La figure 3 montre comment évolue le paramètre de réseau PR en fonction de la concentration x de germanium dans la composition. La pente de la droite 10 vaut + 0,022 nm en fonction du pourcentage atomique de Ge. On peut également citer l'effet de contraintes liées au niveau de dopage d'un film de silicium (par exemple le dopage par le bore à raison de 10¹⁴ à 10²⁰ atomes/cm³) déposé sur une plaque de silicium peu dopée. La figure 4 montre comment évolue le paramètre de réseau PR en fonction de la concentration x d'atomes de bore en pourcentage atomique. La pente de la droite 11 vaut -0,14 nm. On peut inclure ici la notion d'inclusions par nature chimique. Ainsi un film de Ti, déposé sur un support de silicium, puis recouvert par un film encapsulant, garde une forte sensibilité à de l'oxygène (effet "getter" en anglais) qui peut être inclus et peut diffuser à travers le silicium lors d'un traitement thermique consécutif. L'effet induit est la génération d'une zone de contraintes, dite zone d'inclusions.

Pour la génération de contraintes, lors des dépôts des films, on peut citer l'utilisation des paramètres de dépôts tels que la pression de dépôt, la température de dépôt, la puissance de dépôt, la composition de l'atmosphère de dépôt à travers le rapport des pressions partielles des gaz porteurs, des gaz neutres et des gaz réactifs. Il est connu que les contraintes peuvent entraîner, dans les films déposés, un état de forte compression ou de forte tension suivant la pression de dépôt du film. On peut se référer à ce propos à l'article de A. MATERNE et al., intitulé "Changes in Stress and Coercivity after Annealing of Amorphous Co(Zr, Bn) Thin Films Deposited by R.F. Sputtering", E.M.M.A. Conf., Salford, Royaume-Uni, 14-16 septembre 1987. Ainsi, dans le cas de dépôt par pulvérisation cathodique de films de Co(Zr, Nb), une faible pression de l'ordre de quelques mTorr entraînera un état de compression du film alors qu'une forte pression, de l'ordre de quelques dizaines de mTorr, entraînera un état de tension du même matériau. La cause de cette évolution a été attribuée, suivant analyse chimique, à la densité d'argon et d'oxygène incluse dans le film lors du dépôt. L'importance des contraintes est telle que localement elles peuvent, à la limite, provoquer des défauts d'adhérence des films.

Dans le terme de dépôt de films, on inclut tout traitement thermique et/ou physico-chimique, réalisé avant ou après dépôt, visant à induire ces effets dans les films déposés.

Des inclusions peuvent aussi être générées par gravure. La gravure, par voie sèche (ionique, ionique réactive) et/ou par voie chimique "humide" (gravure sélective, gravure anisotrope) et/ou par voie électrochimique permet la réalisation de cavités de tailles choisies, ouvertes sur une très faible surface. Ces cavités peuvent être ou non remplies par la suite d'un matériau piège pour les espèces gazeuses nécessaires au transfert.

Pour générer des inclusions, des techniques de gravure de structures multicouches peuvent être utilisées, assistées plus ou moins par des techniques de masquage partiel sur tout ou partie de la surface de la plaquette (techniques classiques en micro-électronique). Ainsi, dans un film superficiel très mince de nitrure de silicium, il est possible de graver un réseau d'ouvertures de très petites dimensions (sub-microniques). On utilise une technique d'insolation d'un film de résine, positive ou négative, à travers un masque. Sur certaines zones, le film de résine peut être alors retiré chimiquement, par un développeur adapté à la résine utilisée. Dans ces zones découvertes, on peut utiliser une technique de gravure par faisceau d'ions accélérés, dite gravure ionique, pour réaliser des ouvertures dans le film de nitrure de silicium. Ce film superficiel étant déposé à la surface d'un film de silicium, il est alors possible d'attaquer le silicium à l'aplomb des ouvertures réalisées, par gravure à l'hydroxyde de tétraméthylammonium. Cette gravure chimique est très sélective dans la mesure où la vitesse d'attaque du silicium est plus de 100 fois supérieure à celle du nitrure. Il est possible alors de réaliser des cavités plus larges que les ouvertures générées dans le film de nitrure.

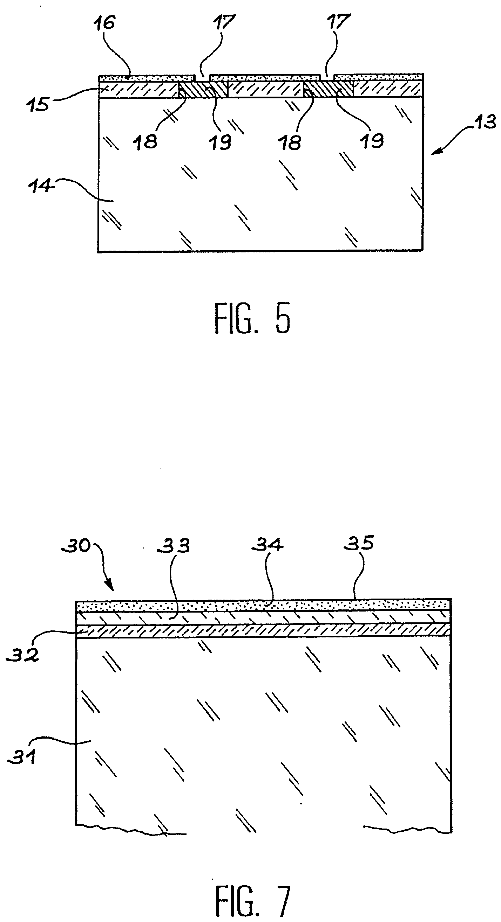

La figure 5 montre une telle réalisation. On y reconnaît un substrat 13 constitué d'un support initial 14 recouvert d'un film de silicium 15. Le film 15 est recouvert d'un film très mince de nitrure de silicium 16 où sont pratiquées des ouvertures 17 de faibles dimensions. A partir des ouvertures 17 on a obtenu des cavités 18 dans le film de silicium 15. En fonction de la dimension des ouvertures 17 réalisées dans le film de nitrure de silicium 16 et de l'épaisseur de ce film 16, il est possible de déposer dans les cavités 18 un matériau 19 dont la nature chimique est propice au piégeage (par exemple du titane pour son effet piège, dit "getter" en anglais) d'espèces gazeuses (par exemple de l'oxygène) implantées lors de l'étape postérieure d'implantation.

Par la suite, on peut éventuellement obstruer les ouvertures réalisées par le dépôt d'une couche. Ce dépôt n'est pas forcément nécessaire, comme par exemple dans le cas du transfert d'une structure de plots réalisés dans un film de silicium cristallin. De même, dans certaines conditions, des traitements thermiques sous atmosphère contrôlée permettent de faciliter, voire d'obtenir, la fermeture de telles cavités. Ces zones de gravure seront considérées, dans le procédé selon l'invention, comme des inclusions, pièges pour les espèces gazeuses implantées par la suite.

Des inclusions peuvent aussi être générées par implantation ionique.

L'implantation par bombardement d'espèces neutres ou d'ions dans un matériau peut engendrer une couche riche en inclusions, à une profondeur spécifique de l'élément implanté. Pour les espèces implantées, on prend alors en compte les effets de freinage électronique et nucléaire par le matériau cible. Dans le procédé selon l'invention, le matériau initial est considéré comme le matériau cible. Le procédé d'implantation peut être fait d'une au plusieurs implantations. Ces implantations peuvent éventuellement être assistées pendant ou entre chaque implantation par un traitement thermique. On trouvera les espèces implantées et les défauts associés au voisinage d'une profondeur moyenne de pénétration Rp (nommée "projected range" en anglais). Les inclusions générées apparaissent comme un désordre à petite échelle dans l'ordre local du matériau. Leur morphologie et leur taille peuvent être modifiées par un traitement thermique et/ou une implantation unique et/ou multiple du même élément ou non.

Comme exemple, on peut citer la réalisation de matériau silicium sur isolant (SOI) par le procédé SIMOX (Séparation par IMplantation d'OXygène). L'implantation à 120 keV d'oxygène est suivie d'un traitement thermique à haute température (par exemple environ 1300° C) pour modifier la topologie et la morphologie des inclusions générées. L'implantation à faible dose (environ 4.1017 O/cm²) d'oxygène, dans une plaque de silicium, permet de réaliser une couche d'oxyde à une profondeur typique de 250 nm, de faible épaisseur (typiquement 80 à 100 nm). Cette couche est défectueuse : elle est plus ou moins continue (présence de canaux de silicium nommés "pipes" en anglais) et elle contient des îlots de silicium (de quelques dizaines de nanomètres comme dimensions typiques), en fonction de la dose implantée. On peut se référer à ce propos à l'article de B. ASPAR et al., intitulé "Ultra Thin Buried Oxide Layers Formed by Low Dose SIMOX Processes", Proc. 6th International Conférence on SOI Technology and Devices, Electroch. Soc., Vol. 94-11 (1994) 62. De même, les interfaces de cette couche d'oxyde avec le film supérieur sont plus ou moins rugueuses en fonction des traitements thermiques imposés. Typiquement, la rugosité d'interface pourra être contrôlée dans une gamme de quelques dixièmes de nanomètres à quelques nanomètres comme cela est mentionné dans l'article intitulé "Characterization by Atomic Force Microscopy cf the SOI Layer Topography in Low-Dose SIMOX Materials" de C. GUILHALMENC et al., paru dans la revue Materials Science and Engineering B 46 (1997) 29-32. Cette couche implantée et ses interfaces seront considérées comme une zone d'inclusions, zones de confinement pour les espèces gazeuses implantées lors de la seconde étape du procédé selon l'invention.

Les traitements thermiques peuvent également être utilisés pour générer des inclusions dans le matériau initial, support ou dans une au moins des couches de la structure en filin(s) à transférer.

A titre d'exemple on citera, pour le silicium, les traitements thermiques, dits "high-low-high" en anglais, permettant de faire précipiter, à une certaine profondeur, l'oxygène présent dans le matériau. Cette profondeur est typiquement de quelques micromètres dans le cas du silicium monocristallin obtenu par tirage Czochralski.

Pour cela, un cycle en température sera typiquement constitué d'un palier à haute température, supérieure à 1000°C, suivi d'un palier à basse température, inférieure à 900°C, de nouveau suivi d'un palier à haute température, supérieure à 1000°C. Un ordre de grandeur de la profondeur x peut être évalué à partir de l'équation de diffusion x Hα(Dt)^{1/2} dans laquelle D est le coefficient de diffusion à la température de traitement thermique et t le temps de la diffusion à cette température. Cette couche générée par des traitements thermiques est considérée comme zone d'inclusions.

Comme autre exemple, les traitements thermiques sont connus pour permettre l'adaptation du niveau de contraintes dans des films déposés par l'une des quelconques méthodes précitées. Ainsi, un traitement thermique au-dessus de 500°C pour un film d'oxyde de silicium, déposé par CVD, permet de réduire la contrainte en compression jusqu'à l'annuler voire la transformer en tension. (Cf. A. SLINTANI et al., J. Appi. Phys. 51(8), p. 4197 (1980)]. Un tel comportement est attribué aux réactions de l'oxyde à la vapeur d'eau. Il peut être interprété comme un effet de dégazage ou comme un effet de densification. De même, une dilatation thermique importante entre un des films et le support initial (ou les autres films) peut provoquer un fort état de contraintes et générer localement des inclusions de contraintes, favorables à piéger des espèces gazeuses. A titre d'exemple, on peut citer le cas de film de silicium (100) élaboré sur saphir, plan R. Les coefficients de dilatation sont respectivement de l'ordre de 4.106/K et 9.106/K. Etant donné que la contrainte est très localisée dans l'épaisseur des films autour de l'interface, cela se traduit par une déformation locale du matériau. Une telle zone perturbée est considérée dans le procédé de l'invention comme une zone d'inclusions.

Une autre façon d'induire une contrainte sur une structure plane en film(s) est de déposer sur la face arrière du support initial un film très contraint permettant une déformation morphologique (concavité ou convexité). La structure en films est alors déformée. La zone localement contrainte dans la structure comportant le ou les films à transférer est dans le procédé selon l'invention une zone d'inclusions pour les espèces gazeuses implantées par la suite.

Le procédé selon l'invention comprend une seconde étape après la génération d'inclusions dans le matériau concerné. Cette seconde étape consiste en une implantation d'espèces gazeuses (atomes, ions) à une profondeur située au voisinage de la couche d'inclusions générées à l'étape précédente. Ces espèces gazeuses sont confinées, grâce à la présence des inclusions. Elles participent à la nucléation et/ou à la croissance de microcavités, microbulles (ou "platelets") nécessaires à la fracture de transfert. Cette implantation peut être réalisée à travers la surface plane de la structure à transférer par bombardement et/ou par diffusion assistée par plasma et/ou par traitement thermique et/ou par polarisation électrique.

Dans le cas d'implantation par bombardement (espèces neutres et/ou ions), ces espèces gazeuses sont implantées à la profondeur moyenne de pénétration, Rp. Cette profondeur est caractéristique de l'énergie d'implantation de l'élément implanté dans une cible donnée. On choisira donc une énergie d'implantation telle que la profondeur Rp correspond au niveau de la zone des inclusions ou telle que la profondeur soit au voisinage de la zone d'inclusions, un traitement thermique de diffusion étant alors utilisé pour permettre la migration des espèces implantées au niveau de la zone des inclusions. Les espèces gazeuses pourront être de gaz rares ou non, telles H, F, He. Elles pourront être implantées simultanément ou successivement.

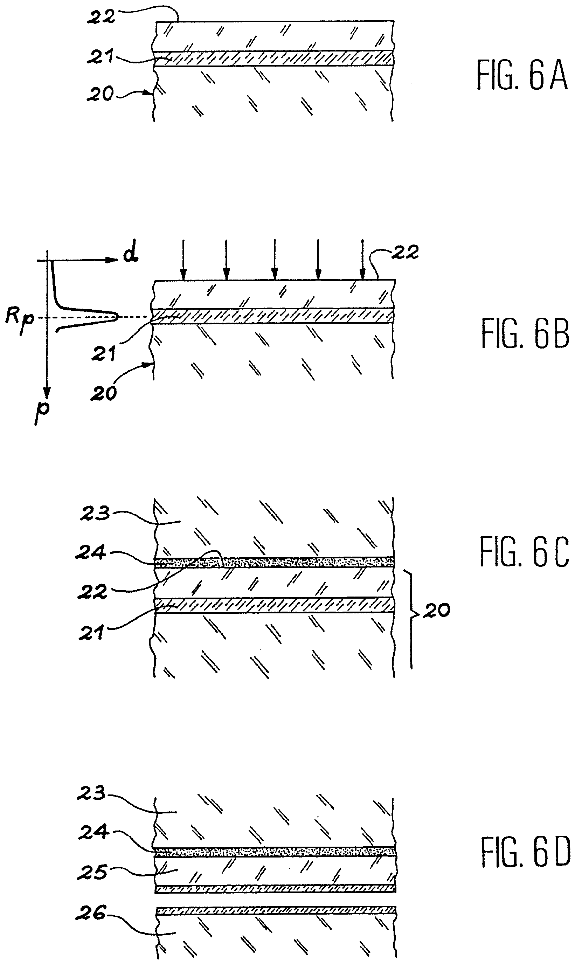

Les figures 6A à 6D illustrent le procédé selon l'invention dans le cas où le film mince est transféré sur un raidisseur. La figure 6A montre un substrat 20 (par exemple formé d'une structure en film(s) mince(s) sur un support initial) comportant une zone d'inclusions 21 formée par l'une des méthodes décrites ci-dessus. La zone d'inclusions est située à une distance de la surface 22 du substrat correspondant à l'épaisseur du film mince à transférer. La figure 6B illustre l'étape d'implantation ionique. Des espèces gazeuses sont implantées, par exemple par bombardement ou par diffusion, au travers de la surface 22 du substrat. La densité d d'espèces gazeuses en fonction de la profondeur p est telle que leur profondeur moyenne Rp de pénétration correspond à la zone d'inclusions 21 qui devient une zone piège, dense en espèces gazeuses. La figure 6C illustre une étape d'adhésion de la surface 22 du substrat 20 à un raidisseur 23 par apport d'une couche intermédiaire 24. D'autres techniques d'adhérence entre la surface 22 et le raidisseur 23, sans apport d'une couche intermédiaire, peuvent aussi être utilisées. La figure 6D illustre l'étape de séparation consécutive à un traitement thermique approprié en fonction du budget thermique requis comme expliqué plus haut. Sur cette figure, la fracture de séparation passe dans la zone de pièges. Le substrat initial est donc partagé en un film mince 25 adhérent au raidisseur 23 et en une partie restante 26. La zone de pièges est montrée ici partagée en deux régions. Cependant, selon les cas, elle peut rester complète en adhérant soit au film mince 25, soit à la partie restante 26 du substrat.

Dans le cas d'implantation par diffusion gazeuse, les espèces peuvent diffuser jusqu'à une profondeur au voisinage de celle des inclusions, en adaptant le temps et la température de diffusion. Les lois de diffusion classiques en (Dt)^{1/2} sont applicables pour adapter la profondeur de diffusion. Ainsi, un traitement thermique sous atmosphère d'argon et d'hydrogène, dans le rapport 9 :1 (dit "forming gas" en anglais), permet la diffusion d'hydrogène dans du silicium, à environ 350°C.

Quel que soit le mode d'implantation, les espèces gazeuses doivent être implantées en une quantité suffisante pour participer à la nucléation et/ou au développement de microcavités, microbulles (ou "platelets") à partir et au voisinage des inclusions décrites précédemment. Les conditions d'implantation (dose, énergie, température de cible, temps d'implantation) dépendent en particulier :
- du matériau initial (cible),
- de la nature et de la localisation des inclusions,
- du budget thermique fourni par l'implantation,
- de la nature des espèces gazeuses implantées,
- du budget thermique fourni postérieurement à un éventuel collage,
- du budget thermique (énergétique) fourni par le traitement thermique, de fragilisation,
- d'éventuelles contraintes mécaniques.
Les doses implantées sont néanmoins inférieures à la dose maximale, dose définie par l'apparition d'exfoliation dans le matériau lors de l'implantation des espèces gazeuses. On définit l'efficacité des inclusions par leur pouvoir de confinement des espèces gazeuses nécessaires au transfert, en considérant la concentration de ces espèces au voisinage des inclusions.

Dans le cas d'implantation ionique, cet effet est illustré par une diminution de la largeur du profil d'implantation, due à une concentration plus importante des espèces implantées autour du Rp d'implantation. Comme exemple, on considère une structure à transférer composée d'un film de Si02 de 0,4 µm d'épaisseur généré sur un support de silicium. Une première implantation ionique d'hydrogène de 3.10¹⁶ H⁺/cm², à l'énergie de 100 keV, destinée à générer les inclusions, provoquera une concentration d'hydrogène à la profondeur moyenne de 0,9 µm. Un traitement thermique est réalisé, typiquement aux environs de 350°C, pendant 2 heures, et est destiné à modifier la morphologie des inclusions (microcavités). On constate que l'épaisseur de la couche contenant les cavités est plus fine que si l'implantation avait été réalisée avec une dose supérieure comme dans le cas du procédé divulgué par le document FR-A-2 681 472. La zone d'inclusions correspond à cette couche de microcavités en cours de croissance. Une deuxième implantation de 2.10¹⁶ H⁺/cm² sera suffisante pour permettre une fracture, au voisinage de cette zone d'inclusions, lors des traitements thermiques de séparation, par exemple à 500°C pendant 1 heure.

On comprend donc l'avantage d'un confinement et d'une localisation possible des microcavités, microbulles (ou "platelets") sur une épaisseur très fine du fait de l'épaisseur de la zone d'inclusions réalisées et/ou de la structure en films utilisées. De même, la rugosité de la surface de fracture sera également réduite du fait du confinement des inclusions et donc de la zone de fracture.

D'une façon générale, il est alors possible de réduire la dose à implanter, nécessaire à la nucléation et/ou au développement de microcavités et/ou de diminuer les forces à exercer et/ou de réduire le budget énergétique du traitement thermique pour induire la fracture.

Le procédé de transfert visant à obtenir une structure finale en film(s) sur un support suppose que le matériau initial soit rapporté sur un deuxième support au cours d'une troisième étape. La mise en contact est soit directe, par adhésion moléculaire (nominée "wafer bonding" en anglais), soit par l'intermédiaire d'une couche d'adhésion. Elle doit permettre au support final d'avoir un rôle de raidisseur. Dans les deux cas de mise en contact, direct et indirect, une étape de fixation par un traitement thermique à basse température peut être nécessaire. Ce traitement doit être adapté pour ne pas empêcher les mécanismes de croissance des microcavités et de fracture dans le matériau initial. Il sera à prendre en compte dans le budget thermique nécessaire pour induire la fracture lors d'une quatrième étape du procédé. Si la structure à transférer est suffisamment rigide et/ou épaisse et que cette étape n'est pas nécessaire, on obtiendra lors du transfert, une structure dite autoportée.

Ainsi, dans l'exemple d'une structure recouverte d'un film de Si02 à transférer sur un support de silicium, une température de l'ordre de 200°C sera suffisante pour renforcer l'adhésion moléculaire. L'énergie de collage entre le film d'oxyde et le support de silicium sera supérieure à 0,3 J/m².

La quatrième étape du procédé de transfert de structures en film(s) nécessite un traitement thermique dont le temps et la température sont définis, en particulier, en fonction de l'efficacité des inclusions créées, de la dose d'espèces gazeuses implantées, des conditions thermiques de l'implantation des espèces gazeuses dans le matériau initial et des conditions thermiques d'adhésion à la plaque support final. Le traitement thermique doit être suffisant pour provoquer une fracture dans le matériau initial. On provoque ainsi une séparation entre une partie du matériau initial non utilisé et la structure en film(s) en contact avec le support final. Cette séparation s'effectue au voisinage de la couche des espèces piégées. Dans les conditions de l'invention, la structure en films (monocouche ou multicouche) peut être transférée avec un budget thermique de fracture réduit en comparaison des budgets thermiques nécessaires dans le procédé selon l'art antérieur. Pour définir le budget thermique de séparation, il faut tenir compte de l'efficacité des inclusions générées et du budget thermique global qui est fourni aux plaques au cours des différentes étapes du procédé, à savoir pendant : la génération des inclusions, l'implantation des espèces gazeuses et l'adhésion du matériau initial sur le support raidisseur.

En outre, une partie de l'énergie nécessaire au transfert des structures peut être apportée par le traitement thermique et/ou à l'aide de contraintes, par exemple : liées à un effet du raidisseur support final, liées à l'application de contraintes de cisaillement, de flexion, de traction, de pression, appliquées seules ou en combinaison. L'effet est de même nature que celui décrit dans le document FR-A-2 748 851. Dans ce cas, la dose minimale d'espèces gazeuses à implanter, lors de la seconde étape du procédé, est celle à partir de laquelle il y a une création et/ou une croissance suffisante de microcavités pour induire la fragilisation suffisante de la plaquette parallèlement à la surface.

La figure 7 illustre une application différente du procédé selon l'invention à l'obtention d'une structure SOI. Le substrat initial 30 est formé à partir d'une plaquette de silicium 31 sur une face de laquelle on dépose un film 32 de silicium d'environ 50 nm d'épaisseur, fortement dopé (environ 10¹⁹ atomes/cm3) par du bore, élaboré par épitaxie. Le film 32 est lui-même recouvert d'un film 33 de silicium, d'environ 350 nm d'épaisseur, faiblement dopé (environ 5.10¹⁵ atomes/cm3) par du bore et également élaboré par épitaxie. Le film 33 est enfin recouvert d'un film 34 de Si02, d'environ 400 nm d'épaisseur et présentant une surface libre 35. Le film 32 de silicium fortement dopé va jouer le rôle de zone d'inclusions.

Le substrat 30 est ensuite soumis à l'étape d'implantation d'espèces gazeuses au travers de la surface 35. On implante de l'hydrogène selon une dose 5.10¹⁶ atomes/cm³, une énergie de 80 keV et à température ambiante.

La surface 35 est ensuite rendue adhérente à une plaque de silicium, par adhésion moléculaire renforcée par un traitement thermique à 250°C pendant 30 minutes.

L'étape de séparation en deux parties du substrat initial 30 comporte un traitement thermique dont l'efficacité par rapport à la fracture est adaptée par le budget thermique (durée et température des différents apports thermiques). Ce traitement thermique final permet d'induire une fracture dans le substrat initial, au niveau et/ou au voisinage du film 32. Le traitement thermique final peut typiquement être de 2 heures à 250°C.

On peut ainsi obtenir une structure formée d'un film de silicium faiblement dopé (le film 33 du substrat initial) sur une couche d'oxyde de silicium (le film 34 du substrat initial), celle-ci étant solidaire d'une masse de silicium. Le film 32 de silicium fortement dopé a servi au confinement de la fracture.

Le procédé selon l'invention s'avère particulièrement intéressant dans le cas de transfert de structures dans lesquelles un ou plusieurs films ne doivent pas subir de traitement thermique à une température aussi élevée de celle impliquée dans le procédé divulgué dans le document FR-A-2 681 472. Il est également intéressant à mettre en oeuvre dans le cas où la structure à transférer est constituée de matériaux ayant des coefficients de dilatation thermique différents.

Enfin, il est important de noter l'avantage suivant du procédé selon l'invention. La surface de la structure en film(s) transférée est une zone perturbée, obtenue lors de la fracture. L'épaisseur de cette zone perturbée peut être très réduite du fait de l'utilisation d'une couche au niveau et/ou au voisinage des inclusions pour confiner la dose d'espèces gazeuses implantées. On obtient, ainsi, une rugosité de surface de la structure transférée faible puisque directement liée à la répartition des microcavités ou microbulles, dans l'épaisseur du matériau lors du transfert.

## Revendications

1. Procédé pour le transfert d'au moins un film mince (25) de matériau solide délimité dans un substrat initial (20), dans lequel le procédé comprend les étapes suivantes :
- la réalisation du substrat initial constitué d'une partie massive supportant une structure en film(s) dans laquelle doit être délimité ledit film mince de matériau solide et, au cours de cette réalisation, la formation d'une couche d'inclusions (3, 7, 32) dans le substrat initial de sorte qu'une fois la réalisation du substrat initial terminée, la couche d'inclusion se trouve à une profondeur correspondant à l'épaisseur désirée pour le film mince, la couche d'inclusion étant formée au moins par une technique de dépôt de film ou une technique de gravure d'une couche (15) du substrat (13),
ladite technique de dépôt de films réalisant des empilements d'un ou de plusieurs films, dans lesquels on fait varier la composition des films, leur état de contrainte, leur structure ou leur morphologie de manière à générer des inclusions formants ladite couche d'inclusions, le dépôt de films désignant le fait de rapporter et/ou d'élaborer ce ou ces films,
ladite technique de gravure d'une couche du substrat comportant la gravure, par voie sèche et/ou par voie chimique humide et/ou par voie électrochimique, de cavités de tailles choisies dans ladite couche du substrat, ouvertes sur une très faible surface, ces cavités formant lesdites inclusions,
ces inclusions étant aptes à constituer une zone de confinement, pour les espèces gazeuses qui seront ensuite implantées, dans une couche perturbée d'épaisseur plus fine que celle que l'on obtiendrait en absence de cette couche d'inclusions, une inclusion étant un volume de matériau dont les propriétés sont différentes de celles du matériau du substrat à partir duquel on veut transférer ledit au moins un film mince, et
- une étape postérieure d'implantation desdites espèces gazeuses, de façon à amener les espèces gazeuses dans la couche d'inclusions (3, 7, 32), la dose des espèces gazeuses implantées étant suffisante pour provoquer la formation de microcavités susceptibles de constituer un plan de fracture permettant la séparation du film mince (25) du reste du substrat (20).

2. Procédé pour le transfert d'au moins un film mince selon la revendication 1, **caractérisé en ce que** l'introduction des espèces gazeuses est une implantation réalisée par un bombardement d'espèces gazeuses.

3. Procédé pour le transfert d'au moins un film mince selon la revendication 2, **caractérisé en ce que** l'étape d'implantation desdites espèces gazeuses est réalisée avec une énergie d'implantation de ces espèces gazeuses telle que leur profondeur moyenne de pénétration dans le substrat (20) correspond à la profondeur de la couche d'inclusions (3, 7, 32).

4. Procédé pour le transfert d'au moins un film mince selon la revendication 2, **caractérisé en ce que** l'étape d'implantation desdites espèces gazeuses est réalisée avec une énergie d'implantation de ces espèces gazeuses telle que leur profondeur moyenne de pénétration dans le substrat (20) est au voisinage de la couche d'inclusions (3, 7, 32), cette implantation étant associée avec un traitement thermique de diffusion pour permettre la migration des espèces implantées au niveau de la couche d'inclusions (3, 7, 32).

5. Procédé pour le transfert d'un film mince selon l'une quelconque des revendications précédentes, **caractérisé en ce que** tout ou partie de ladite structure est obtenu par épitaxie.

6. Procédé pour le transfert d'un film mince selon l'une quelconques des revendications précédentes, **caractérisé en ce que** ladite structure est telle que, après transfert dudit film mince, le reste du substrat, porteur ou non d'une épitaxie, est réutilisable pour un autre transfert de film minces.

7. Procédé pour le transfert d'un film mince selon l'une quelconques des revendications précédents, **caractérisé en ce que** la formation de la couche d'inclusions par la technique de dépôt de film consiste en une génération de colonnes pour obtenir la couche d'inclusions.

8. Procédé pour le transfert d'un film mince selon l'une quelconques des revendications 1 à 7, **caractérisé en ce que** la formation de la couche d'inclusions par la technique de dépôt de film consiste en une génération de joints de grains pour obtenir la couche d'inclusions.

9. Procédé pour le transfert d'un film mince selon l'une quelconque des revendications précédentes, **caractérisé en ce que** la couche d'inclusions par la technique du dépôt de film comporte un traitement thermique du ou des films de la structure de films pour obtenir la couche d'inclusions.

10. Procédé pour le transfert d'un film mince selon l'une quelconque des revendications précédentes **caractérisé en ce que** la formation de la couche d'inclusions par la technique de dépôt de film comporte l'application de contraintes au(x) film(s) de la structure en film(s) pour obtenir la couche d'inclusions.

11. Procédé pour le transfert d'un film mince selon l'une quelconque des revendications 2 à 10, **caractérisé en ce que** les espèces gazeuses sont choisies parmi les espèces neutres et les ions.

12. Procédé pour le transfert d'un film mince selon l'une quelconque des revendications 1 à 11, **caractérisé en ce que** l'implantation des espèces gazeuses est réalisée par une méthode choisie parmi la diffusion assistée par plasma, la diffusion thermique et la diffusion assistée par plasma combinée avec la diffusion thermique et/ou assistée par polarisation électrique.

13. Procédé pour le transfert d'un film mince selon l'une quelconque des revendications 1 à 12, **caractérisé en ce qu'**il comprend une étape de traitement thermique apte à fragiliser le substrat au niveau de la couche d'inclusions pour permettre la séparation entre le film mince (25) et le reste du substrat (26).

14. Procédé pour le transfert d'un film mince selon l'une quelconque des revendications 1 à 13, **caractérisé en ce qu'**il comprend en outre une étape de mise en contact intime du film mince (25) délimité dans le substrat avec un support (23) auquel le film mince adhérera après sa séparation d'avec le reste (26) du substrat.

15. Procédé pour le transfert d'un film mince selon l'une quelconque des revendications 1 à 14 **caractérisé en ce qu'**il comprend la mise en oeuvre de contraintes mécaniques pour contribuer à la séparation entre le film mince et le reste du substrat.

## Patentansprüche

1. Verfahren zum Übertragen mindestens eines, in einem Ausgangssubstrat (20) abgegrenzten, Dünnfilms (25) aus einem festen Werkstoff, wobei das Verfahren die folgenden Schritte umfasst:
- die Herstellung des Ausgangssubstrats, das aus einem massiven Teil besteht, der eine Struktur aus Film(en) trägt, in der der Dünnfilm aus einem festen Werkstoff abgegrenzt werden soll, während dieser Herstellung die Bildung einer Schicht von Einschlüssen (3, 7, 32) in dem Ausgangssubstrat, derart, dass nach Beendigung der Herstellung des Ausgangssubstrats die Einschlussschicht sich in einer Tiefe befindet, die der für den Dünnfilm gewünschten Dicke entspricht, wobei die Einschlussschicht mindestens durch eine Filmabscheidungstechnik oder eine Technik zum Ätzen einer Schicht (15) des Substrats (13) gebildet wird,
wobei die Technik zur Abscheidung von Filmen Stapel aus einem oder mehreren Filmen herstellt, wobei man die Zusammensetzung der Filme, ihren Spannungszustand, ihre Struktur oder ihre Morphologie variiert, so dass Einschlüsse erzeugt werden, die die Schicht von Einschlüssen bilden, wobei Filmabscheidung die Tatsache der Verbindung und/oder der Ausarbeitung des Films oder der Filme bezeichnet,
wobei die Technik zum Ätzen einer Schicht des Substrats das Trockenätzen und/oder das nasschemische Ätzen und/oder das elektrochemische Ätzen von Hohlräumen ausgewählter Größen in der Schicht des Substrats mit einer sehr kleinen offenen Oberfläche beinhaltet, wobei diese Hohlräume die Einschlüsse bilden,
wobei die Einschlüsse dafür ausgelegt sind, eine Abgrenzungszone für die gasförmigen Spezies, die anschließend implantiert werden, in einer gestörten Schicht mit einer kleineren Dicke als diejenige, die man in Abwesenheit dieser Schicht von Einschlüssen erhalten würde, zu bilden, wobei ein Einschluss ein Volumen des Werkstoffs ist, dessen Eigenschaften verschieden von denjenigen des Werkstoffs des Substrats sind, aus dem man den mindestens einen Dünnfilm übertragen möchte, und
- einen anschließenden Schritt der Implantation der gasförmigen Spezies, um die gasförmigen Spezies in die Schicht von Einschlüssen (3, 7, 32) einzubringen, wobei die Dosis der implantierten gasförmigen Spezies ausreicht, um die Bildung von Mikrohohlräumen zu bewirken, die eine Bruchebene bilden können, welche die Abtrennung des Dünnfilms (25) von dem Rest des Substrats (20) ermöglichen.

2. Verfahren zum Übertragen mindestens eines Dünnfilms nach Anspruch 1, **dadurch gekennzeichnet, dass** das Einbringen der gasförmigen Spezies eine durch Beschuss mit gasförmigen Spezies durchgeführte Implantation ist.

3. Verfahren zum Übertragen mindestens eines Dünnfilms nach Anspruch 2, **dadurch gekennzeichnet, dass** der Schritt der Implantation der gasförmigen Spezies mit einer derartigen Implantationsenergie dieser gasförmigen Spezies durchgeführt wird, dass ihre mittlere Eindringtiefe in das Substrat (20) der Tiefe der Schicht von Einschlüssen (3, 7, 32) entspricht.

4. Verfahren zum Übertragen mindestens eines Dünnfilms nach Anspruch 2, **dadurch gekennzeichnet, dass** der Schritt der Implantation der gasförmigen Spezies mit einer derartigen Implantationsenergie dieser gasförmigen Spezies durchgeführt wird, dass ihre mittlere Eindringtiefe in das Substrat (20) in der Nähe der Schicht von Einschlüssen (3, 7, 32) liegt, wobei die Implantation mit einer thermischen Diffusionsbehandlung einhergeht, um die Wanderung der implantierten Spezies in die Ebene der Schicht von Einschlüssen (3, 7, 32) zu ermöglichen.

5. Verfahren zum Übertragen eines Dünnfilms nach einem der vorhergehenden Ansprüche, **dadurch gekennzeichnet, dass** die gesamte oder ein Teil der Struktur durch Epitaxie erhalten wird.

6. Verfahren zum Übertragen eines Dünnfilms nach einem der vorhergehenden Ansprüche, **dadurch gekennzeichnet, dass** die Struktur derart ist, dass nach der Übertragung des Dünnfilms der Rest des Substrats, der eine Epitaxie trägt oder nicht, für eine weitere Dünnfilmübertragung verwendet werden kann.

7. Verfahren zum Übertragen eines Dünnfilms nach einem der vorhergehenden Ansprüche, **dadurch gekennzeichnet, dass** die Bildung der Schicht von Einschlüssen durch die Filmabscheidungstechnik aus der Erzeugung von Säulen besteht, um die Schicht von Einschlüssen zu erhalten.

8. Verfahren zum Übertragen eines Dünnfilms nach einem der Ansprüche 1 bis 7, **dadurch gekennzeichnet, dass** die Bildung der Schicht von Einschlüssen durch die Filmabscheidungstechnik aus der Erzeugung von Kornverbindungen besteht, um die Schicht von Einschlüssen zu erhalten.

9. Verfahren zum Übertragen eines Dünnfilms nach einem der vorhergehenden Ansprüche, **dadurch gekennzeichnet, dass** die Schicht von Einschlüssen durch die Filmabscheidungstechnik eine thermische Behandlung des Films oder der Filme der Struktur aus Filmen beinhaltet, um die Schicht von Einschlüssen zu erhalten.

10. Verfahren zum Übertragen eines Dünnfilms nach einem der vorhergehenden Ansprüche, **dadurch gekennzeichnet, dass** die Bildung der Schicht von Einschlüssen durch die Filmabscheidungstechnik das Anlegen von Spannungen an den Film bzw. die Filme der Struktur aus Film(en) beinhaltet, um die Schicht von Einschlüssen zu erhalten.

11. Verfahren zum Übertragen eines Dünnfilms nach einem der Ansprüche 2 bis 10, **dadurch gekennzeichnet, dass** die gasförmigen Spezies aus neutralen Spezies und Ionen ausgewählt sind.

12. Verfahren zum Übertragen eines Dünnfilms nach einem der Ansprüche 1 bis 11, **dadurch gekennzeichnet, dass** die Implantation der gasförmigen Spezies durch ein Verfahren durchgeführt wird, das aus plasmagestützter Diffusion, thermischer Diffusion sowie plasmagestützter Diffusion kombiniert mit thermischer Diffusion und/oder unterstützt durch elektrische Polarisation ausgewählt ist.

13. Verfahren zum Übertragen eines Dünnfilms nach einem der Ansprüche 1 bis 12, **dadurch gekennzeichnet, dass** es einen Schritt der thermischen Behandlung umfasst, der dafür ausgelegt ist, das Substrat an der Schicht von Einschlüssen zu schwächen, um die Trennung zwischen dem Dünnfilm (25) und dem Rest des Substrats (26) zu ermöglichen.

14. Verfahren zum Übertragen eines Dünnfilms nach einem der Ansprüche 1 bis 13, **dadurch gekennzeichnet, dass** es außerdem einen Schritt umfasst, bei dem der in dem Substrat abgegrenzte Dünnfilm (25) in einen engen Kontakt mit einem Träger (23) gebracht wird, an dem der Dünnfilm nach seiner Trennung von dem Rest (26) des Substrats haftet.

15. Verfahren zum Übertragen eines Dünnfilms nach einem der Ansprüche 1 bis 14, **dadurch gekennzeichnet, dass** es das Anwenden von mechanischen Spannungen, um die Trennung zwischen dem Dünnfilm und dem Rest des Substrats zu unterstützen, umfasst.

## Claims

1. Method for transferring at least one thin film (25) of solid material defined within an initial substrate (20), wherein the method comprises the following steps:
- the production of the initial substrate consisting of a solid part supporting a film or multifilm structure within which said thin film of solid material must be defined and, during this production, the formation of a layer of inclusions (3, 7, 32) in the initial substrate so that once the production of the initial substrate is completed, the layer of inclusions is found at a depth corresponding to the desired thickness for the thin film, the layer of inclusions being formed at least by a film deposition technique or a technique of etching a layer (15) of the substrate (13),
said film deposition technique producing stacks of one or more films, in which stacks the composition of the films, their state of stress, their structure or their morphology are varied so as to generate inclusions forming said layer of inclusions, the deposition of films denoting the fact of adding and/or producing this or these films,
said technique of etching a layer of the substrate comprising dry etching and/or wet chemical etching and/or electrochemical etching of cavities of chosen sizes in said layer of the substrate, which are open over a very small surface area, these cavities forming said inclusions,
these inclusions being capable of constituting a confinement zone for the gaseous species that will then be implanted, in a disturbed layer of thinner thickness than that which would be obtained in the absence of this layer of inclusions, an inclusion being a volume of material having properties different from those of the material of the substrate from which it is desired to transfer said at least one thin film, and
- a subsequent step of implanting said gaseous species, so as to bring the gaseous species into the layer of inclusions (3, 7, 32), the dose of gaseous species implanted being sufficient to cause the formation of microcavities capable of constituting a fracture plane allowing the thin film (25) to be separated from the remainder of the substrate (20).

2. Method for transferring at least one thin film according to Claim 1, **characterized in that** the introduction of the gaseous species is an implantation carried out by bombardment of gaseous species.

3. Method for transferring at least one thin film according to Claim 2, **characterized in that** the step of implanting said gaseous species is carried out with an implantation energy of these gaseous species such that their mean depth of penetration into the substrate (20) corresponds to the depths of the layer of inclusions (3, 7, 32).

4. Method for transferring at least one thin film according to Claim 2, **characterized in that** the step of implanting said gaseous species is carried out with an implantation energy of these gaseous species such that their mean depth of penetration into the substrate (20) is in the vicinity of the layer of inclusions (3, 7, 32), this implantation being combined with a thermal diffusion treatment in order to allow migration of the implanted species within the layer of inclusions (3, 7, 32).

5. Method for transferring a thin film according to any one of the preceding claims, **characterized in that** all or part of said structure is obtained by epitaxy.

6. Method for transferring a thin film according to any one of the preceding claims, **characterized in that** said structure is such that, after said thin film has been transferred, the rest of the substrate, which may or may not carry an epitaxial growth, can be reused for another thin-film transfer.

7. Method for transferring a thin film according to any one of the preceding claims, **characterized in that** the formation of the layer of inclusions by the film deposition technique consists of a generation of columns to obtain the layer of inclusions.

8. Method for transferring a thin film according to any one of Claims 1 to 7, **characterized in that** the formation of the layer of inclusions by the film deposition technique consists of a generation of grain boundaries to obtain the layer of inclusions.

9. Method for transferring a thin film according to any one of the preceding claims, **characterized in that** the layer of inclusions by the film deposition technique comprises a heat treatment of the film or films of the multifilm structure to obtain the layer of inclusions.

10. Method for transferring a thin film according to any one of the preceding claims, **characterized in that** the formation of the layer of inclusions by the film deposition technique comprises applying stresses to the film(s) of the film or multifilm structure to obtain the layer of inclusions.

11. Method for transferring a thin film according to any one of Claims 2 to 10, **characterized in that** the gaseous species are chosen from neutral species and ions.

12. Method for transferring a thin film according to any one of Claims 1 to 11, **characterized in that** the implantation of the gaseous species is carried out by a method chosen from plasma-assisted diffusion, thermal diffusion and plasma-assisted diffusion combined with thermal diffusion and/or diffusion assisted by an electrical bias.

13. Method for transferring a thin film according to any one of Claims 1 to 12, **characterized in that** it includes a heat treatment step capable of embrittling the substrate at the layer of inclusions in order to allow the thin film (25) to be separated from the remainder (26) of the substrate.

14. Method for transferring a thin film according to any one of Claims 1 to 13, **characterized in that** it furthermore includes a step of bringing the thin film (25) defined in the substrate into intimate contact with a support (23) to which the thin film will bond after it has been separated from the remainder (26) of the substrate.

15. Method for transferring a thin film according to any one of Claims 1 to 14, **characterized in that** it includes the use of mechanical stresses to help to separate the thin film from the remainder of the substrate.
